**Europäisches Patentamt**

**European Patent Office**

**Office européen des brevets**

(19)

(11) **EP 1 039 305 A1**

(12) **EUROPÄISCHE PATENTANMELDUNG**

(43) Veröffentlichungstag:
27.09.2000 Patentblatt 2000/39

(51) Int. Cl.$^7$: **G01R 31/08**

(21) Anmeldenummer: **00105034.3**

(22) Anmeldetag: **09.03.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **26.03.1999 DE 19913954**

(71) Anmelder:
**NOKIA MOBILE PHONES LTD.**
**02150 Espoo (FI)**

(72) Erfinder: **Pietsch, Andreas**
**48249 Dülmen (DE)**

(74) Vertreter:
**TER MEER STEINMEISTER & PARTNER GbR**
**Patentanwälte,**
**Mauerkircherstrasse 45**
**81679 München (DE)**

(54) **Verfahren zur Ermittlung der Position einer in einem Antennenpfad vorhandenen Fehlstelle sowie Kommunikationsvorrichtung zur Durchführung des Verfahrens**

(57) Beschrieben werden ein Verfahren und eine Kommunikationsvorrichtung aus einem Funktelefon (5) mit angeschlossenem Antennenpfad (1), mit deren Hilfe sich eine Fehlstelle (F) im Antennenpfad (1) exakt lokalisieren läßt, um den Antennenpfad (1) gezielt reparieren zu können. Hierzu wird zunächst eine Welle mit einer Startfrequenz (f0) In den Antennenpfad (1) eingekoppelt und die Amplitude der stehenden Welle an einer Winkelposition gemessen. Danach wird die Frequenz der Welle so lange erhöht, bis an derselben Winkelposition eine entsprechende Amplitude detektiert wird. Aus den dann vorhandenen Frequenzen und einem Zählwert (n), der angibt, wie oft die entsprechende Amplitude erhalten worden ist, wird sodann der Fehlerabstand (Ed) zwischen Detektor (18) und Fehlstelle (F) errechnet.

Fig. 1

## Beschreibung

Die Erfindung betrifft ein Verfahren gemäß dem Anspruch 1 sowie eine Kommunikationsvorrichtung gemäß dem Anspruch 13.

In zunehmendem Maße werden heutzutage Funktelefone in Fahrzeuge installiert, entweder nachträglich durch den Kunden selbst oder schon bei der Produktion der Fahrzeuge, bei denen es sich zum Beispiel um Kraftfahrzeuge handeln kann oder um irgendwelche anderen Fahrzeuge mit Funkkommunikationsvorrichtungen, etwa, Schiffe, Flugzeuge, Züge, usw.. So ist zum Beispiel der Einbau von zwei Antennenpfaden für GSM-(Global System for Mobile Communications) Antennen möglich, die als normale oder Notfallantennen arbeiten können. Beim Einbau oder während des späteren Betriebs der Fahrzeuge besteht allerdings die Gefahr, daß die jeweiligen Koaxialleitungen, die Stekker oder die Antennen selbst beschädigt werden. Eine einwandfreie Kommunikation über diese Antennen ist dann nur noch schwer oder überhaupt nicht mehr möglich. Entsprechende Probleme können auch in Antennenzweigen von Global Positioning Systemen (GPS) auftreten.

Aus der DE 44 34 915 C1 sind bereits ein Verfahren und eine Anordnung zum Ermitteln der Fehlanpassung einer an eine Signalquelle angeschlossenen Last, insbesondere einer an einen Sender angeschlossenen Antenne, bekannt. Bei dem bekannten Verfahren wird in den Antennenzweig eine abzustrahlende Leistung eingespeist, eine im Antennenzweig reflektierte Leistung (durch Auskopplung eines Anteils) erfaßt und es werden die ausgekoppelten Anteile der eingespeisten Leistung und die reflektierte Leistung einer Auswertung zugeführt. Dazu werden die beiden Leistungen in Beziehung zueinander gesetzt, um so ein die Güte des Antennenzweigs angebendes Qualitätssignal zu erhalten.

Es läßt sich somit feststellen, ob ein Antennenzweig defekt ist oder nicht. Bejahendenfalls muß dieser dann ausgetauscht werden, was relativ zeitaufwendig und kostenintensiv ist.

Der Erfindung liegt die Aufgabe zugrunde, ein Verfahren und eine Kommunikationsvorrichtung anzugeben, mit denen sich die Position einer Fehlstelle im Antennenzweig relativ exakt bestimmen läßt.

Die verfahrensseitige Lösung der gestellten Aufgabe findet sich im Anspruch 1. Dagegen findet sich eine vorrichtungsseitige Lösung der gestellten Aufgabe im Anspruch 13. Vorteilhafte Ausgestaltungen der Erfindung sind den Unteransprüchen zu entnehmen.

Ein erfindungsgemäßes Verfahren zur Ermittlung der Position einer in einem elektrischen Leitungspfad vorhandenen und signalreflektierende Eigenschaften aufweisende Fehlstelle umfaßt folgende Schritte: in den Leitungspfad bzw. Antennenpfad wird ein eine Startfrequenz aufweisendes Signal eingekoppelt; mittels eines Detektors wird die Amplitude einer stehenden Welle an einer festen Winkelposition der Schwingung betragsmäßig gemessen, wobei sich die stehende Welle zwischen Fehlstelle und Detektor durch Reflexion des eingekoppelten Signals an der Fehlstelle aufbaut; es wird die Frequenz des eingekoppelten Signals so lange in einer Richtung verändert, bis nach wenigstens einmal 180° der Detektor wieder einen entsprechenden Amplitudenbetrag der sich ausbildenden stehenden Welle an der genannten Winkelposition detektiert; und ein Zählwert, der angibt, wie oft der Detektor diesen Amplitudenbetrag detektiert hat, wird zusammen mit der jeweils dazugehörigen Frequenz und der Startfrequenz zur Ermittlung eines Fehlerabstands zwischen Detektor und Fehlstelle herangezogen.

Dabei kann vorzugsweise der Fehlerabstand Ed durch folgende Gleichung ermittelt werden:

$$Ed = X \cdot \frac{c}{f0}$$

mit

$$X = \frac{n}{2} \cdot \frac{1}{\left( \dfrac{fn}{f0} - 1 \right)}$$

Hierin sind Ed der Fehlerabstand, n der Zählwert mit den Werten 1, 2, 3, usw., f0 die Startfrequenz, fn mit den Werten n = 1, 2, 3, usw. die Frequenz des eingekoppelten Signals beim Zählwert n = 1, 2, 3, usw., und c die Ausbreitungsgeschwindigkeit des Signals im Leitungspfad. Dabei errechnet sich c vorzugsweise durch den Ausdruck

$$c = \frac{1}{\sqrt{\mu0 \; \varepsilon0 \; \varepsilon r}}$$

Hierin sind $\mu0$ die Permeabilitätskonstante, $\varepsilon0$ die Dielektrizitätskonstante und $\varepsilon r$ die relative Dielektrizitätskonstante des Leitungspfads.

Da die Dämpfung der sich entlang des Leitungspfads ausbreitenden Wellen von der Frequenz abhängt, werden nach einer vorteilhaften Weiterbildung der Erfindung vom Detektor normierte Amplitudenbeträge gemessen. Zur Bildung der normierten Amplitudenbeträge werden dabei die Amplituden der eingestrahlten und reflektierten Wellen zueinander in Beziehung gesetzt, also Stehwellenverhältnisse gebildet.

Grundsätzlich ist es möglich, an jeder Winkelposition der vollen Schwingung, also über den Bereich $2\pi$ bzw. 360°, die jeweiligen Amplitudenbeträge zu erfassen. So können zum Beispiel die Amplitudenbeträge im Bereich der Minima der stehenden Welle gemessen werden oder im Bereich der Maxima der stehenden Welle. Dies erleichtert die Messung der jeweiligen Amplitudenbeträge ganz erheblich. Auch ist damit eine Vereinfachung des Schaltungsaufbaus verbunden.

Vorzugweise wird die Frequenz des eingekoppelten Signals ausgehend von der Startfrequenz stetig verändert, wodurch sich die Position von Fehlstellen entlang des Leitungspfads noch genauer ermitteln läßt. Allerdings könnten auch Frequenzsprünge ausgeführt werden, jedoch dürften diese nicht zu groß sein. Dabei kann die Frequenz des eingekoppelten Signals ausgehend von der Ausgangsfrequenz je nach Wunsch entweder erhöht oder verringert werden.

Kommt als Leitungspfad ein Antennenpfad eines Funktelefons zum Einsatz, so werden vorzugsweise solche Frequenzen verwendet, auf denen das Funktelefon auch senden kann. Hier kann es sich um die Frequenzen des GSM-Bandes handeln. Eine gesonderte Testvorrichtung zum Testen des Antennenpfads kann somit entfallen.

Das Verfahren selbst kann zum Beispiel nach Installation des Antennenpfads in einem Fahrzeug bzw. Kraftfahrzeug unter Verwendung des Funktelefons als Sender ausgeführt werden, also im letzten Herstellungsschritt der Kommunikationsvorrichtung. Möglich ist es aber auch, das Verfahren periodisch oder mit jeder Inbetriebnahme des Funktelefons auszuführen, um die Betriebsbereitschaft der Kommunikationsvorrichtung auch über einen längeren Zeitraum zu gewährleisten.

Eine erfindungsgemäße Kommunikationsvorrichtung besteht aus einem in einem Fahrzeug installierten Antennenpfad sowie einem Funktelefon, das mit dem Antennenpfad verbindbar ist. Das Funktelefon enthält dabei folgendes: einen Sender zum Einkoppeln eines eine Startfrequenz aufweisenden Signals in den Antennenpfad; einen Detektor zum betragsmäßigen Messen der Amplitude einer stehenden Welle an einer festen Winkelposition, wobei sich die stehende Welle zwischen dem Detektor und einer im Leitungspfad vorhandenen Fehlstelle ausbildet; eine Steuereinrichtung zur Änderung der Frequenz des eingekoppelten Signals so lange in einer Richtung, bis nach wenigstens 180° der Detektor wieder einen entsprechenden Amplitudenbetrag der sich ausbildenden stehenden Welle an der genannten Winkelposition detektiert; einen Zähler, der zählt, wie oft der Detektor diesen Amplitudenbetrag detektiert hat; und eine Recheneinrichtung zur Berechnung des Abstands der Fehlstelle vom Detektor anhand der Startfrequenz, eines Zählwerts des Zählers sowie der zum jeweiligen Zählwert gehörenden Frequenz des eingekoppelten Signals.

Ausführungsbeispiele der Erfindung werden nachfolgend unter Bezugnahme auf die Zeichnung im einzelnen beschrieben. Es zeigen:

**Figur 1** ein Signaldiagramm zur Erläuterung der Grundlagen, auf dem das erfindungsgemäße Verfahren basiert;
**Figur 2** ein Blockschaltbild eines ersten Ausführungsbeispiels einer erfindungsgemäßen Kommunikationsvorrichtung;
**Figur 3** ein Blockschaltbild eines zweiten Ausführungsbeispiels der erfindungsgemäßen Kommunikationsvorrichtung; und
**Figur 4** ein Blockschaltbild eines dritten Ausführungsbeispiels der erfindungsgemäßen Kommunikationsvorrichtung.

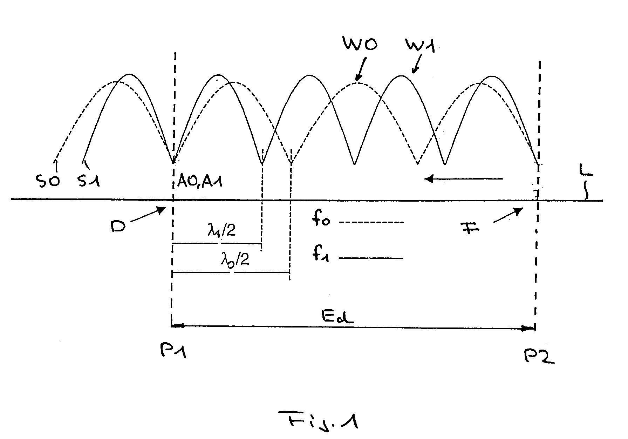

Nachfolgend sollen zunächst die Grundlagen des erfindungsgemäßen Verfahrens unter Bezugnahme auf die Figur 1 erläutert werden.

Die Figur 1 zeigt als durchgezogene horizontale Linie einen Leitungspfad L, der an einer Position P2 eine Fehlstelle F aufweist, die signalreflektierende Eigenschaften hat. Es kann sich hier bei der Fehlstelle F um eine Leitungsunterbrechung, einen Kurzschluß, usw., handeln. Weiterhin befindet sich im Leitungspfad L an einer Position P1 ein Detektor D, der im Abstand Ed zur Fehlstelle F liegt. Dieser Detektor D ist in der Lage, die Amplitude einer Welle bzw. deren Betrag zu messen, die sich entlang des Leitungspfads L ausbreitet.

Zunächst sei angenommen, daß über einen nicht dargestellten Sender ein erstes Signal S0 mit einer Startfrequenz f0 von links in Figur 1 auf den Leitungspfad L gegeben wird. Dieses Signal S0 wird an der Fehlstelle F reflektiert, so daß sich eine stehende Welle W0 ausbildet. Der Abstand Ed sei hier zufällig so gewählt, daß der Detektor D im Minimum der stehenden Welle W0 positioniert ist. Er mißt daher einen minimalen Amplitudenbetrag A0. Dieser Amplitudenbetrag A0 wird zunächst zwischengespeichert.

Sodann wird die Frequenz des eingekoppelten Signals verändert, und zwar kontinuierlich so lange erhöht, bis der Detektor das nächste sich ausbildende Minimum der jetzt zwischen P1 und P2 vorhandenen stehenden Welle W1 des eingekoppelten Signals S1 detektiert. Mit anderen Worten mißt der Detektor D jetzt die Amplitude A1.

Beide Amplituden A0 und A1 werden bezogen auf die jeweiligen stehenden Wellen W0, W1 an denselben Winkelpositionen der jeweiligen Schwingungen gemessen (hier zum Beispiel 0°).

Berücksichtigt man, daß einerseits an der Fehlstelle F jeweils ein Minimum der stehenden Wellen W0, W1 vorhanden sein muß und andererseits am Ort des Detektors ebenfalls jeweils ein Minimum gemessen wird, so müssen für diesen speziellen Fall im Abstand Ed ganzzahlig Vielfache der halben Wellenlänge der jeweils stehenden Wellen W0 und W1 liegen. Dies läßt sich durch nachfolgende Gleichung (1) ausdrücken:

$$X \cdot \lambda 0 = \left(X + \frac{n}{2}\right) \cdot \lambda 1 \tag{1}$$

Hierin sind $\lambda 0$ und $\lambda 1$ jeweils die Wellenlänge der Signale S0 und S1 mit den Frequenzen f0 und f1, n ein Zählwert, der angibt, wieviele Male der Detektor D ausgehend von der Startfrequenz f0 erneut einen minimalen Amplitudenbetrag detektiert hat (im vorliegenden Fall ist n = 1), und X ein Bemessungswert. Löst man die obige Gleichung (1) nach X auf und setzt statt der Wellenlänge die jeweilige Frequenz der Signale ein, so ergibt sich die Gleichung (2):

$$X = \frac{n}{2} \cdot \frac{1}{\left(\dfrac{fn}{f0} - 1\right)} \tag{2}$$

Im vorliegenden Fall ist n = 1, so daß für fn in Gleichung (2) der Wert f1 einzusetzen ist.

Mit Gleichung (2) ergibt sich dann der Abstand Ed gemäß nachfolgender Gleichung (3):

$$Ed = X \cdot \frac{c}{f0} \tag{3}$$

Hierin ist c die Ausbreitungsgeschwindigkeit des in den Leitungspfad L eingekoppelten Signals und bestimmt sich im wesentlichen durch nachfolgende Gleichung (4):

$$c = \frac{1}{\sqrt{\mu 0 \, \varepsilon 0 \, \varepsilon r}} \tag{4}$$

Hierin sind $\mu 0$ die Permeabilitätskonstante, $\varepsilon 0$ die Dielektrizitätskonstante des Vakuums und $\varepsilon r$ die relative Dielektrizitätskonstante des Leitungspfads L.

Würde man im obigen Beispiel nach Figur 1 die Frequenz noch weiter auf einen Wert f2 erhöhen, bei dem der Detektor D zum zweiten Mal einen minimalen Amplitudenwert der sich dann ausgebildeten stehenden Welle mißt, also A2, so müßte in obiger Gleichung (3) für den Ausdruck n der Wert 2 eingesetzt werden, usw..

Als Beispiel sei nachfolgende Tabelle angegeben.

Tabelle

| Startfrequenz f0 = 890 MHz | X = 17,8 | Ed = 5,99 m |
|---|---|---|
| Stoppfrequenz f1 = 915 MHz | X = 18,3 | Ed = 5,99 m |
| Stoppfrequenz f2 = 940 MHz | X = 18,8 | Ed = 5,99 m |
| Stoppfrequenz f3 = 965 MHz | X = 19,3 | Ed = 5,99 m |

Hier ergibt sich unter Verwendung der Startfrequenz f0 und der ersten Stoppfrequenz f1 ein Wert X = 18,3, was zu einer Fehlerdistanz Ed von 5,99 m führt. Bei Verwendung der Startfrequenz f0 und der zweiten Stoppfrequenz F2 ergibt sich ein Wert X von 18,8, was jedoch zur selben Fehlerdistanz Ed von 5,99 m führt, usw.. Dazu sei erwähnt, daß hier noch nicht der Faktor $1/\sqrt{\mu_0\,\varepsilon_0\,\varepsilon_r}$ berücksichtigt worden ist, da die Materialkonstanten des Leitungspfads L nicht eingesetzt wurden. Änderungen der Frequenz im oben beschriebenen Umfang führen aber zu keinen signifikanten Veränderungen der obigen Abstände untereinander, so daß sich in Jedem Fall Bereiche ermitteln lassen, In denen ein Fehler im Leitungspfad L vorliegt. Bei Berücksichtigung der Materialkonstanten des Leitungspfads L sind dann die obigen Federabstände Ed entsprechend kleiner.

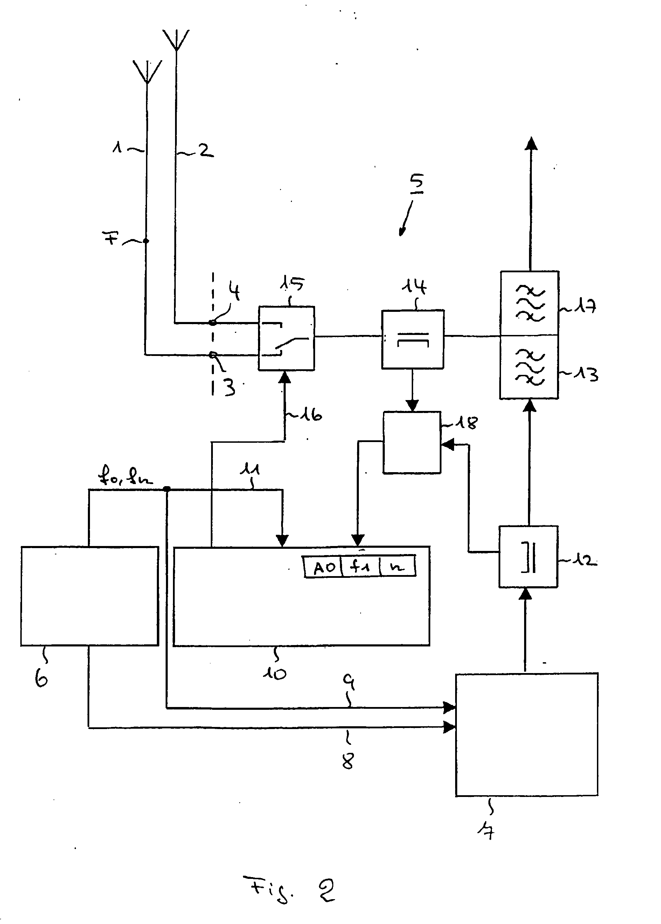

Die Figur 2 zeigt ein erstes Ausführungsbeispiel einer Kommunikationsvorrichtung, die nach dem erfindungsgemäßen Verfahren arbeitet.

Die Kommunikationsvorrichtung, die zum Beispiel in einem Kraftfahrzeug installiert sein kann, enthält zwei im Kraftfahrzeug eingebaute Antennenpfade 1 und 2, die jeweils über Klemmen 3 und 4 mit entsprechenden Ausgängen eines Funktelefons 5 verbunden werden können, bei dem es sich zum Beispiel um ein tragbares Funktelefon bzw. Handy handeln kann, das in eine entsprechende und im Kraftfahrzeug installierte Aufnahme einsetzbar ist. Einer der Antennenpfade 1 läßt sich dabei während des normalen Betriebs des Funktelefons 5 verwenden, während der andere Antennenpfade 2 zum Beispiel mit einer Notfallantenne verbunden ist. Entsprechend der jeweiligen Situation läßt sich einer der Antennenpfade 1, 2 auswählen.

Das digitale Funktelefon 5 selbst weist einen digitalen Signalprozessor (DSP) 6 auf, dessen Schaltungen fest verdrahtet sind, so daß er nicht programmierbar ist. Dies macht ihn relativ schnell und er ist daher für zeitkritische Abläufe einsetzbar. Einer dieser Abläufe ist zum Beispiel die Zusammenstellung der zu versendenden Bursts. Bei einem TDMA-Verfahren wie GSM laufen dabei die Sprachdaten von einem Mikrophon-/Sprachcoder des Funktelefons 5 kontinuierlich ein und der digitale Signalprozessor 6 stellt die digitalen Datenpakete zusammen, die In den vorbestimmten Zeitschlitzen von einem ausgangsseitig mit ihm verbundenen Sender 7 verschickt werden müssen. Der digitale Signalprozessor 6 schickt deshalb die Daten über eine Datenleitung 8 zu einem Sendezeitpunkt an den Sender 7 und schickt gleichzeitig ein Steuersignal über eine Leitung 9 an den Sender 7, um ihn zum Sendezeitpunkt einzuschalten.

Dasselbe Steuersignal, das vom digitalen Signalprozessor 6 über die Leitung 9 zum Sender 7 geliefert wird, erhält auch ein Mikroprozessor 10 über eine Leitung 11. Somit weiß auch der Mikroprozessor 10, wann Daten über den Sender 7 ausgesendet werden. Ferner teilt der digitale Signalprozessor 6 dem Sender 7 und dem Mikroprozessor 10 über die Leitungen 9 und 11 mit, welche Sendefrequenz verwendet wird.

Im normalen Betrieb wird die Senderfrequenz. die das Funktelefon verwenden soll, in einer Nachricht von der Basisstation mitgeteilt. Der Mikroprozessor 10 erhält diese Nachricht durch Auswertung der von der Basisstation empfangenen Bursts.

Die vom Sender 7 ausgangsseitig verschickten Signale gelangen über einen unidirektionalen Meßrichtkoppler 12 zu einem TX-Antennenfilter 13 und weiter über einen zweiten unidirektionalen Meßrichtkoppler 14 zu einem Eingang eines Antennenschalters 15. Je nach Stellung des Antennenschalters 15 werden dann die vom Sender 7 ausgesandten Signale in den Antennenpfad 1 oder in den Antennenpfad 2 eingekoppelt. Ein Steuersignal für die Auswahl der Schaltstellung des Antennenschalters 15 wird in Abhängigkeit von vorbestimmten Bedingungen vom Mikroprozessor 10 über eine Steuerleitung 16 zum Antennenschalter 15 geliefert.

Über einen der Antennenpfade 1 oder 2 empfangene Signale werden über den Antennenschalter 15 und den unidirektionalen Meßrichtkoppler 14 einem RX-Filter 17 zugeleitet und über dieses Filter in den Empfangskreis des Funktelefons 5 eingespeist. Dies soll im weiteren nicht genauer erläutert werden. Erwähnt sei in diesem Zusammenhang nur, daß im GSM-System die Basisstation zu den Mobilstationen mit einer Frequenz von 935 bis 960 MHz sendet, während die Mobilstationen zu der Basisstation mit einer Frequenz von 890 bis 915 MHz senden. Um zu erreichen, daß der Empfänger der Mobilstation nur Signale von der Basisstation erhält und um zu verhindern, daß von der Mobilstation ausgesandte Leistung in den eigenen Empfänger gesendet wird, Ist das RX-Filter 17 bzw. Bandpaßfilter vorgesehen, das nur Frequenzen von 935 bis 960 MHz passieren läßt. Dagegen läßt das TX-Filter 13 entsprechend nur Frequenzen im Bereich von 890 bis 915 MHz passieren. Die Filter könnten theoretisch auch durch einen Schalter ersetzt werden, der, gesteuert vom Mikroprozessor 10, ständig zwischen Sende- und Empfangsbetrieb umschaltet.

Der Meßrichtkoppler 12, dessen Aufbau allgemein bekannt ist, koppelt einen Teil der auszusendenden und vom Sender 7 abgegebenen Welle aus und liefert diesen Teil zu einem Detektor 18, der die Amplitude der ausgekoppelten Welle detektiert. Dagegen ist der unidirektionale Meßrichtkoppler 14 in der Lage, an Fehlstellen in den Antennenpfaden 1 oder 2 reflektierte Signale ebenfalls auszukoppeln und zum Detektor 18 zu übertragen. Auch von diesen Signalen mißt der Detektor 18 die Amplitude und ist somit in der Lage, ein Stehwellenverhältnis zwischen ursprünglich ausgesandter Welle und an einer Fehlerstelle reflektierter Welle zu bilden. Die Bildung dieses Stehwellenverhältnisses erfolgt kontinuierlich über die gesamte Wellenlänge der Schwingung. Da der Mikroprozessor 10 vom digitalen Signalprozessor 6 über die Frequenz der ausgesandten Welle informiert wird, kann der Mikroprozessor 10 das gebildete Stehwellenverhältnis derjenigen Winkelposition $\alpha$ innerhalb einer Periode der ausgesandten Welle zuordnen, an der gerade gemessen wird.

Mit anderen Worten ist der Mikroprozessor 10 in der Lage, das Stehwellenverhältnis zum Beispiel im Minimum der stehenden Welle anzugeben, im Maximum der stehenden Welle oder an einer beliebig anderen Winkelposition $\alpha$.

Soll mit der erfindungsgemäßen Kommunikationsvorrichtung ermittelt werden, ob sich Fehler in den Antennenpfaden 1 und 2 befinden, und soll ermittelt werden, an welcher Position sich diese Fehler befinden, so wird die Kommunikationsvorrichtung zunächst in eine Testbetriebsart umgeschaltet. Dies kann unmittelbar nach Installation der Kommunikationsvorrichtung in ein Fahrzeug erfolgen oder vor jeder Inbetriebnahme bzw. nach jedem unmittelbaren Einschalten der Vorrichtung.

Sei angenommen, daß der Antennenschalter 15 den Antennenpfad 1 mit dem Funktelefon 5 verbindet, und befindet sich im Antennenpfad 1 eine Fehlstelle, an der Reflexionen auftreten, so wird zunächst mittels des Senders 7 das bereits zuvor erwähnte Signal S0 in den Antennenzweig 1 eingekoppelt und dort an der Fehlstelle reflektiert. Die Frequenz f0 des Signals S0 kann dabei so gewählt werden, daß der Detektor 18 das Stehwellenverhältnis im Minimum der sich ausbildenden stehenden Welle W0 mißt, wie in Figur 1 gezeigt. Dieses Stehwellenverhältnis wird In Form der Amplitude A0 betragsmäßig im Mikroprozessor 10 zwischengespeichert.

Jetzt wird die Frequenz der vom Sender 7 ausgesandten Welle stetig erhöht. Der Detektor 18 mißt ständig das Stehwellenverhältnis der sich frequenzmäßig verändernden Welle und stellt fest, wann ein dem zuvor ermittelten Stehwellenverhältnis entsprechendes Stehwellenverhältnis erscheint. Tritt dieser Fall auf, wird die dazugehörige höhere Frequenz des vom Sender 7 ausgesandten Signals im Mikroprozessor 10 gespeichert. Der Mikroprozessor 10 zählt darüber hinaus in Abhängigkeit des Ausgangssignals des Detektors 18, wie oft das entsprechende Stehwellenverhältnis bei Erhöhung der Frequenz des vom Sender 7 ausgesandten Signals erhalten wird. Es genügt im Prinzip, die Frequenz des Startsignals so weit zu erhöhen, bis zum ersten Mal ein dem ursprünglichen Stehwellenverhältnis entsprechendes Stehwellenverhältnis erneut erhalten wird. In diesem Fall ist dann der Zählwert des Zählers n = 1.

Unter Heranziehung der Frequenz f0 des Startsignals, die ebenfalls im Mikroprozessor 10 zwischengespeichert wird, der Frequenz f1 und dem Zählwert n = 1 läßt sich dann der Fehlerabstand Ed zwischen Detektor und Fehlstelle F gemäß Gleichung (2) und Gleichung (3) errechnen. Wird mit Gleichung (4) noch die Materialkonstante des Antennenpfads berücksichtigt, ergibt sich ein relativ exakter Fehlerab stand, so daß dann gezielt eine Reparatur des Antennenpfads erfolgen kann.

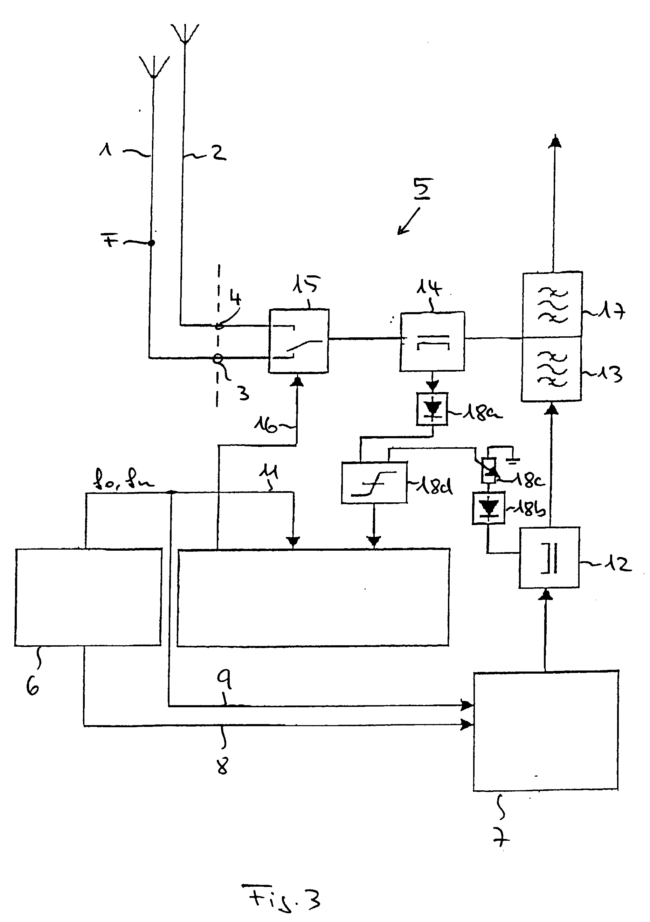

Die Figur 3 zeigt ein zweites Ausführungsbeispiel der erfindungsgemäßen Kommunikationsvorrichtung. Es handelt sich hier um eine analoge Variante. Mittels eines regelbaren Widerstandes 18c kann eine Spannung, die an einen Schwellwertschalter 18d geliefert wird, eingestellt werden. Dies wird in der Regel beim Justieren des Funktelefons 5 nach der Produktion vorgenommen. Falls erforderlich, kann sie auch bei der Wartung des Funktelefons nachjustiert werden. Der Schwellwertschalter 18d in Form einer Quotienten-Bildungsstufe dient zur Bildung des Stehwellenverhältnisses, wie bereits eingangs erwähnt. Mit ihm läßt sich feststellen, ob ein Defekt im Antennenpfad vorliegt, damit ihm die Detektion der Maxima der rücklaufenden bzw. reflektierten Welle möglich ist. Sobald am unidirektionalen Meßwertkoppler 14 ein Maximum bei einer Frequenz festgestellt wird, schickt der Schwellwertschalter 18d ein positives Signal an den Mikroprozessor 10a, bei allen anderen darunter liegenden Werten ein negatives Signal. Natürlich werden auch hier wieder im Mikroprozessor 10a die Frequenz f0, die Frequenz fn und der Zählwert n gespeichert. Die Berechnung des Fehlerabstands Ed erfolgt dann wiederum in Übereinstimmung mit den Gleichungen (2) und (3) bzw. (4). Statt im Maximum zu messen, könnte auch am anderen Ort gemessen werden, wozu die Schwelle oder ein Schwellenbereich entsprechend eingestellt werden müßten.

Mit den Bezugszeichen 18a und 18b sind im Ausführungsbeispiel nach Figur 3 noch Diodengleichrichter bezeichnet. Sie richten die aus den unidirektionalen Meßwertkopplern 12 und 14 ausgekoppelten Signale der ausgesandten und reflektierten Welle gleich. Das aus dem Meßwertkoppler 12 ausgekoppelte hinlaufende bzw. ausgesandte Signal gelangt somit über den Diodengleichrichter 18b und den Widerstand 18c zu einem Eingang des Schwellwertschalters 18d (Referenzeingang), während das aus dem Meßrichtkoppler 14 ausgekoppelte Signal über den Diodengleichrichter 18a zu einem anderen Eingang des Schwellwertschalters 18d gelangt.

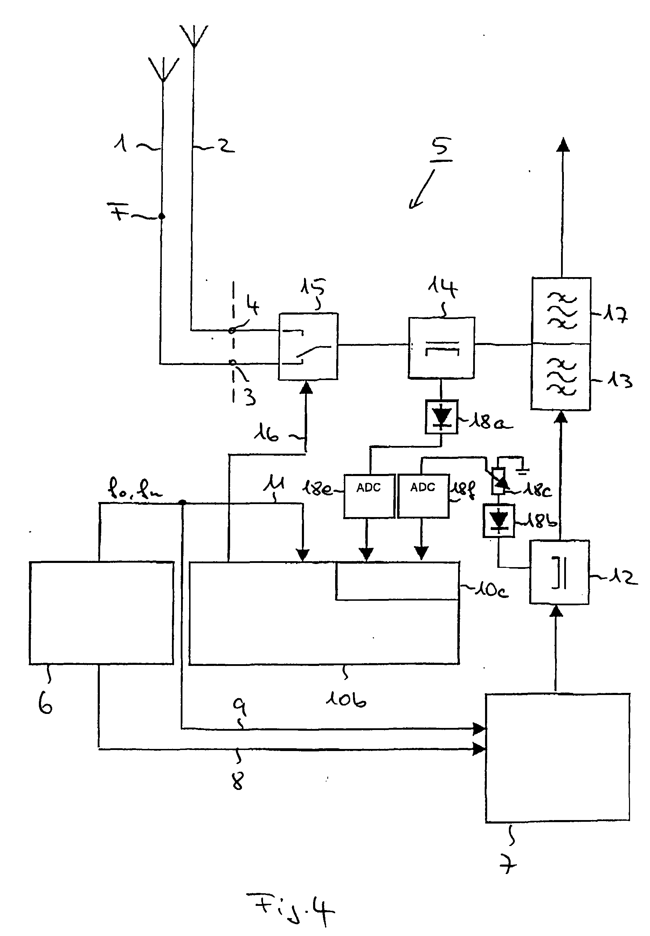

Die Figur 4 zeigt ein noch weiteres Ausführungsbeispiel einer erfindungsgemäßen Kommunikationsvorrichtung. Gleiche Elemente wie in Figur 2 sind wiederum mit den gleichen Bezugszeichen versehen und werden nicht nochmals beschrieben. Es handelt sich hier um eine digitale Variante. Auch hier sind die Diodengleichrichter 18a und 18b sowie der regelbare Widerstand 18c vorhanden, wie bereits unter Bezugnahme auf die Figur 3 beschrieben. Im Gegensatz zur analogen Variante werden jedoch die von den Gleichrichtern gelieferten Spannungen der hin- und rücklaufenden Welle sofort Analog-/Digital-Wandlern 18e und 18f zugeführt, um in digitale Signale umgewandelt zu werden. Der Mikroprozessor 10b kann jetzt die ankommenden Daten verwenden, um die Berechnungen gemäß den Gleichungen (2), (3) und (4) zur Lokalisierung der Fehlstelle F durchzuführen. Hierzu weist der Mikroprozessor 10b einen Verarbeitungsteil 10c auf, in welchem zunächst die Stehwellenverhältnisse gebildet und zusammen mit den Frequenzen f0 und fn sowie dem Zählwert n zwischengespeichert werden.

Der Mikroprozessor 10b könnte auch die Justierung, die durch den regelbaren Widerstand 18c erfolgt, elektronisch durchführen.

**Patentansprüche**

1.   Verfahren zur Ermittlung der Position einer in einem elektrischen Leitungspfad (L) vorhandenen und signalreflektierenden Eigenschaften aufweisenden Fehlstelle (F), mit folgenden Schritten:

   -   in den Leitungspfad (L) wird ein eine Startfrequenz (f0) aufweisendes Signal (S0) eingekoppelt;
   -   mittels eines Detektors (D) wird die Amplitude (A0) einer stehenden Welle (W0) an einer festen Winkelposition (2) betragsmäßig gemessen, wobei sich die stehende Welle (W0) zwischen Fehlstelle (F) und Detektor (D) durch Reflexion des eingekoppelten Signals (S0) an der Fehlstelle (F) aufbaut;
   -   es wird die Frequenz des eingekoppelten Signals so lange in einer Richtung verändert, bis nach wenigstens einmal 180° der Detektor (D) wieder einen entsprechenden Amplitudenbetrag (A1) der sich ausbildenden stehenden Welle (W1) an der genannten Winkelposition ($\alpha$) detektiert; und
   -   ein Zählwert n, der angibt wie oft der Detektor (D) diesen Amplitudenbetrag (A1) detektiert hat, wird zusammen mit der jeweils dazugehörigen Frequenz (fn) und der Startfrequenz (f0) zur Ermittlung eines Fehlerabstands (Ed) zwischen Detektor (D) und Fehlstelle (F) herangezogen.

2.   Verfahren nach Anspruch 1, **dadurch gekennzeichnet**, daß der Fehlerabstand (Ed) durch folgende Gleichung ermittelt wird:

$$Ed = X \cdot \frac{c}{f0}$$

mit

$$X = \frac{n}{2} \cdot \frac{1}{\left( \dfrac{fn}{f0} - 1 \right)}$$

und

$$c = \frac{1}{\sqrt{\mu0 \ \varepsilon0 \ \varepsilon r}}$$

worin der Zählwert n = 1, 2, 3,..., f0 die Startfrequenz, fn mit n = 1, 2, 3, ... die Frequenz des eingekoppelten Signals beim Zählwert n = 1, 2, 3, ..., c die Ausbreitungsgeschwindigkeit des Signals im Leitungspfad, $\mu0$ die Permeabilitätskonstante, $\varepsilon0$ die Dielektrizitätskonstante und $\varepsilon r$ die relative Dielektrizitätskonstante des Leitungspfads sind.

3. Verfahren nach Anspruch 1 oder 2, **dadurch gekennzeichnet**, daß der Detektor (D) normiert Amplitudenbeträge mißt.

4. Verfahren nach Anspruch 1, 2 oder 3, **dadurch gekennzeichnet**, daß der Detektor (D) die Amplitudenbeträge im Bereich der Minima der stehenden Welle mißt.

5. Verfahren nach Anspruch 1, 2 oder 3, **dadurch gekennzeichnet**, daß der Detektor (D) die Amplitudenbeträge im Bereich der Maxima der stehenden Welle mißt.

6. Verfahren nach einem der Ansprüche 1 bis 5, **dadurch gekennzeichnet**, daß die Frequenz des eingekoppelten Signals ausgehend von der Startfrequenz (f0) stetig verändert wird.

7. Verfahren nach einem der Ansprüche 1 bis 6, **dadurch gekennzeichnet**, daß die Frequenz des eingekoppelten Signals ausgehend von der Startfrequenz (f0) erhöht wird.

8. Verfahren nach einem der Ansprüche 1 bis 7, **dadurch gekennzeichnet**, daß als Leitungspfad (L) ein Antennenpfad eines Funktelefons zum Einsatz kommt.

9. Verfahren nach Anspruch 8, **dadurch gekennzeichnet**, daß als Frequenzen (f0, fn) solche zum Einsatz kommen, auf denen das Funktelefon senden kann.

10. Verfahren nach einem der Ansprüche 1 bis 9, **dadurch gekennzeichnet**, daß sämtliche Frequenzen (f0, fn) im GSM-Band liegen.

11. Verfahren nach einem der Ansprüche 8 bis 10, **dadurch gekennzeichnet**, daß es nach Installation des Antennenpfads in einem Kraftfahrzeug unter Verwendung des Funktelefons als Sender ausgeführt wird.

12. Verfahren nach Anspruch 11, **dadurch gekennzeichnet**, daß es periodisch oder mit jeder Inbetriebnahme des Funktelefons ausgeführt wird.

13. Kommunikationsvorrichtung mit einem in einem Fahrzeug installierten Antennenpfad (1) sowie einem Funktelefon (5), das mit dem Antennenpfad (1) verbindbar Ist, wobei das Funktelefon (5) folgendes enthält:

   - einen Sender (7) zum Einkoppeln eines eine Startfrequenz (f0) aufweisenden Signals (S0) in den Antennenpfad (1);
   - einen Detektor (18) zum betragsmäßigen Messen der Amplitude (A0) einer stehenden Welle (W0) an einer festen Winkelposition ($\alpha$), wobei sich die stehende Welle (W0) zwischen dem Detektor (18) und einer im Antennenpfad (1) vorhandenen Fehlstelle (F) ausbildet;
   - eine Steuereinrichtung (6) zur Änderung der Frequenz des eingekoppelten Signals so lange In einer Richtung, bis nach wenigstens 180° der Detektor (18) wieder einen entsprechenden Amplitudenbetrag (A1) der sich ausbildenden stehenden Welle (W1) an der genannten Winkelposition ($\alpha$) detektiert;
   - einen Zäher (10), der zählt, wie oft der Detektor (18) diesen Amplitudenbetrag (A1) detektiert hat; und
   - eine Recheneinrichtung (10) zur Berechnung des Abstands (Ed) der Fehlstelle (F) vom Detektor (18) anhand der Startfrequenz (f0), eines Zählwerts (n) des Zählers (10) sowie der zum jeweiligen Zählwert (n) gehörenden Frequenz (fn) des eingekoppelten Signals.

Fig. 1

Fig. 2

Fig. 3

Fig.4

**Europäisches Patentamt**

## EUROPÄISCHER RECHERCHENBERICHT

Nummer der Anmeldung

EP 00 10 5034

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 5 068 614 A (FIELDS WALTER D ET AL) 26. November 1991 (1991-11-26) * Zusammenfassung; Ansprüche 1,3; Abbildungen * * Spalte 1, Zeile 14 - Zeile 54 * * Spalte 5, Zeile 17 - Zeile 30 * | 1,13 | G01R31/08 |
| A | EP 0 859 237 A (NOKIA MOBILE PHONES LTD) 19. August 1998 (1998-08-19) * Zusammenfassung; Abbildungen * | 13 | |
| A | EP 0 524 837 A (NIPPON SHEET GLASS CO LTD) 27. Januar 1993 (1993-01-27) * Zusammenfassung; Abbildungen 3-8 * | 1,13 | |
| A | DONG C: "FREQUENCY DOMAIN REFLECTOMETRY: AN OLD CONCEPT WITH A NEW APPLICATION" MICROWAVE JOURNAL,US,HORIZON HOUSE. DEDHAM, Bd. 39, Nr. 7, 1. Juli 1996 (1996-07-01), Seite 124,126,128,13 XP000679082 ISSN: 0192-6225 * Seite 124, linke Spalte, Absatz 1 - Absatz 2 * | 1,13 | RECHERCHIERTE SACHGEBIETE (Int.Cl.7) G01R |
| A | US 4 630 228 A (TARCZY-HORNOCH ZOLTAN ET AL) 16. Dezember 1986 (1986-12-16) * Zusammenfassung; Abbildungen * | 1,13 | |

Der vorliegende Recherchenbericht wurde für alle Patentansprüche erstellt

| Recherchenort | Abschlußdatum der Recherche | Prüfer |
|---|---|---|
| BERLIN | 12. Mai 2000 | Fritz, S |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

## ANHANG ZUM EUROPÄISCHEN RECHERCHENBERICHT
## ÜBER DIE EUROPÄISCHE PATENTANMELDUNG NR.

EP 00 10 5034

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-05-2000

| Im Recherchenbericht angeführtes Patentdokument | Datum der Veröffentlichung | Mitglied(er) der Patentfamilie | Datum der Veröffentlichung |
|---|---|---|---|
| US 5068614 A | 26-11-1991 | JP 5196684 A | 06-08-1993 |
| EP 0859237 A | 19-08-1998 | DE 19705735 A<br>JP 10267978 A | 20-08-1998<br>09-10-1998 |
| EP 0524837 A | 27-01-1993 | JP 5026944 A<br>US 5337004 A | 05-02-1993<br>09-08-1994 |
| US 4630228 A | 16-12-1986 | KEINE | |

EPO FORM P0461